# EUROPÄISCHE PATENTSCHRIFT

(11) **EP 1 606 879 B1**
(45) Veröffentlichungstag und Bekanntmachung des Hinweises auf die Patenterteilung: **02.08.2006**
(21) Anmeldenummer: 04719995.5
(22) Anmeldetag: 12.03.2004
(51) Int. Cl.: H03K 19/18

(54) **MAGNETISCHE LOGIKEINRICHTUNG UND VERFAHREN ZU DEREN BETRIEB**
MAGNETIC LOGIC DEVICE AND METHOD FOR THE OPERATION THEREOF
DISPOSITIF LOGIQUE MAGNETIQUE ET PROCEDE PERMETTANT DE LE FAIRE FONCTIONNER

(30) Priorität: 17.03.2003 DE 10311717
(43) Veröffentlichungstag der Anmeldung: 21.12.2005
(73) Patentinhaber: Forschungsverbund Berlin e.V., 12489 Berlin (DE)
(72) Erfinder: Koch, Reinhold, 14050 Berlin (DE); Pampuch, Carsten, 14197 Berlin (DE); Ney, Andreas, 12167 Berlin (DE); Das, Amal K., c/o Dept. of Physics & Meteorology, Kharagpur 721302 (IN)
(74) Vertreter: Hertz, Oliver
(86) Internationale Anmeldenummer: PCT/EP2004/002612
(87) Internationale Veröffentlichungsnummer: WO 2004/084410

(56) Entgegenhaltungen:
- DE-C- 10 053 206
- DE-C- 10 113 787
- BLACK W C ET AL: "PROGRAMMABLE LOGIC USING GIANT-MAGNETORESISTANCE AND SPIN-DEPENDENTTUNNELING DEVICES (INVITED)" JOURNAL OF APPLIED PHYSICS, AMERICAN INSTITUTE OF PHYSICS. NEW YORK, US, Bd. 87, Nr. 9, 1. Mai 2000 (2000-05-01), Seiten 6674-6679, XP000954082 ISSN: 0021-8979
- SHEN J: "LOGIC DEVICES AND CIRCUITS BASED ON GIANT MAGNETORESISTANCE" IEEE TRANSACTIONS ON MAGNETICS, IEEE INC. NEW YORK, US, Bd. 33, Nr. 6, November 1997 (1997-11), Seiten 4492-4497, XP000831058 ISSN: 0018-9464

## Beschreibung

Die Erfindung betrifft magnetische Logikeinrichtungen mit den Merkmalen gemäß dem Oberbegriff von Anspruch 1, aus derartigen Logikeinrichtungen zusammengesetzte Logikschaltungen und Verfahren zu deren Betrieb.

Logikschaltungen, die aus einer Vielzahl frei programmierbarer Bauelemente bestehen und rekonfigurierbare Systeme bilden, sind allgemein bekannt. Es ist beispielsweise eine Anordnung programmierbarer Logikeinrichtungen vorgesehen, die über programmierbare Verbindungen je nach der aktuellen Aufgabe zusammenschaltbar sind (sogenannte "Field Programmable Gate Arrays", FPGA). FPGA-Schaltungen benötigen für die Programmierbarkeit Halbleiterbauelemente, die mit Hilfe eines gespeicherten Ladungszustandes die Logik der Schaltung festlegen. Dafür werden ferroelektrische Materialien verwendet, die eine Ladung über eine lange Zeit speichern und damit einen definierten Zustand stabil halten können. Nachteilig ist jedoch, dass Umprogrammierungen, bei denen die Ladung verändert wird, mit einer mechanischen Belastung des speichernden Materials verbunden sind. Daher sind die Betriebsfrequenz und Lebensdauer von ferroelektrischen Speichern begrenzt.

Die Beschränkung auf eine bestimmte Anzahl von Umschaltzyklen kann mit magnetischen Logikeinrichtungen überwunden werden, deren logische Funktion beispielsweise durch ein magnetoresitives Element (im Folgenden: MR-Element) ausgeführt wird. MR-Elemente besitzen einen elektrischen Widerstand, der auf der Grundlage z. B. des GMR- (giant magnetoresistive) oder des TMR- (tunneling magnetoresistive)-Effekts durch ein äußeres Magnetfeld verändert und zur Erzeugung von logisch verknüpften Signalen verwendet werden kann (siehe W. C. Black et al. in "Journal of Applied Physics", Band 87, 2000, S. 6674-6679).

MR-Elemente, die in der Regel Dünnschichtbauelemente sind, können beliebig oft umgeschaltet werden und sind dadurch gekennzeichnet, dass ein aktueller Betriebszustand (hier: Magnetisierungszustand) spannungslos gespeichert wird (Nichtflüchtigkeit der Information). Daher besitzen MR-Bauelemente eine erheblich reduzierte Leistungsaufnahme und des weiteren die Fähigkeit, Informationen prinzipiell mit extrem kurzen Impulsen (fs) und extrem hohen Frequenzen (GHz) zu schreiben oder zu lesen (siehe T. Gerrits et al. in "Nature", Band 418, 2002, S. 509). Bisher werden MR-Elemente wegen der genannten Vorteile als Speicherbausteine (MRAM, Magnetic Random Access Memory, siehe z.B. DE 198 53 447), d. h. als passives Bauelement verwendet. Es sind die folgenden Versuche bekannt, MR-Elemente auch als aktive Bauelemente in Logikeinrichtungen zu verwenden.

In DE 100 36 356 ist ein MR-Element mit drei magnetisierbaren Schichten beschrieben, das eine so genannte magnetische Diode bildet. Nachteile der magnetischen Diode bestehen in deren komplexem Aufbau und der beschränkten Funktionalität. Durch Umschaltung der Magnetisierungsrichtung einer der Teilschichten kann zwar eine logische Funktion invertiert werden (z. B. AND zu NAND). Eine frei programmierbare Logikschaltung, die auch ein Umschalten zwischen verschiedenen Grundoperationen (z. B. AND zu OR) erfordert, ist mit der Logikeinrichtung gemäß DE 100 36 356 jedoch nicht realisierbar.

In DE 100 44 395 C1 wird ein Baustein für eine programmierbare magnetische Logik vorgeschlagen, der zwei MR-Elemente jeweils mit einer magnetischen Informationsschicht und einer magnetischen Referenzschicht aufweist. Die Anwendung dieses ebenfalls kompliziert aufgebauten Bausteins ist auf die Erzeugung zweier Ausgangssignale beschränkt, die zueinander invertiert sind.

In der o. g. Publikation von W. C. Black et al. wird eine feldprogrammierte magnetische Logikschaltung beschrieben, die mehrere MR-Elemente und zugeordnete MR-Referenzelemente umfasst. Um ein Logikgrundelement zu bilden, werden mindestens drei MR-Elemente benötigt. Welche logische Funktion das Logikgrundelement ausführt, wird durch eine Einstellung an einem MR-Element und seinem zugeordneten MR-Referenzelement definiert. Der Nachteil dieser herkömmlichen Logikschaltung besteht im hohen Schaltungsaufwand. Des Weiteren ist zur Funktionsprogrammierung das Umschalten von mindestens zwei MR-Elementen erforderlich.

Von W. C. Black et al. wird in der genannten Publikation des weiteren die Logikfunktion eines einzelnen MR-Elements erläutert, das schematisch in Figur 4 illustriert ist. Die herkömmliche Logikeinrichtung 10' umfasst ein MR-Element 11' mit magnetisierbaren Schichten (Stellelementen) 12', 13', zwei Eingangsleitungen 14', 15', einer Ausgangsleitung 16' und einer RESET-Leitung 17'. Die Eingangsleitungen 14', 15' sind zu einer gemeinsamen Signalleitung 18' verbunden, mit der das MR-Element 11' magnetisierbar ist. Mit der Logikeinrichtung 10' wird eine logische OR-Operation wie folgt ausgeführt.

Zunächst erfolgt ein Rücksetzen des MR-Elements 11', indem die RESET-Leitung 17' mit einem vorbestimmten RESET-Strom beaufschlagt wird. Die Stellelemente 12', 13' werden dadurch beispielsweise mit antiparallelen Magnetisierungen magnetisiert (siehe Pfeile). Entsprechend ist der Widerstand des MR-Elements 11' zunächst hoch, so dass das logische Ausgangssignal O einer logischen "0" entspricht. Wenn an mindestens einer oder beiden der Eingangsleitungen 14', 15' ein logisches "1"-Signal anliegt (Eingangsstrom: Ein), wird eine der Schichten (z. B. 12') ummagnetisiert, während die andere Schicht ihre Magnetisierung beibehält. Im Ergebnis verringert sich der Widerstand des MR-Elements, und es ergibt sich ein Ausgangssignal "1" (OR-Funktion). Die entsprechende NOR-Funktion kann durch Umkehrung der Magnetisierung der anderen Schicht (hier: 13') erzielt werden.

Ein Nachteil der herkömmlichen Logikeinrichtung 10' ist es, dass die Ausführung der Logikfunktion von der Stärke der Magnetfelder abhängt, die mit den Eingangsleitungen 14', 15' entsprechend der jeweiligen Eingangsgrößen erzeugt werden. Für eine zuverlässige Funktion müssen die Magnetfelder auch im Langzeitbetrieb reproduzierbar einstellbar sein, das heißt es werden relativ hohe Anforderungen an die Konstanz der Ströme über die Eingangsleitungen 14', 15' gestellt. Des Weiteren kann die Stärke der unterschiedlich lokal wirkenden Magnetfelder nachteiligerweise durch externe Magnetfelder gestört und damit die Funktion der Logikeinrichtung eingeschränkt werden.

Nachteilig an der Logikeinrichtung 10' mit dem einzelnen MR-Element ist des weiteren die Beschränkung auf eine bestimmte Logikfunktion. Um nicht die OR-, sondern die AND-Funktion zu realisieren, müssen andere Signalströme eingestellt oder andere magnetische Materialien verwendet werden.

In DE 100 53 206 C1 ist eine programmierbare Logikeinrichtung ebenfalls mit einem einzelnen MR-Element beschrieben, das als magnetische Stellelemente zwei magnetische Schichten enthält. Die Stellelemente sind analog zu Figur 4 durch Beaufschlagung eines elektrischen Leiters mit Signalströmen, die für logische Eingangsgrößen charakteristisch sind, einzeln oder gemeinsam magnetisierbar. Die Logikeinrichtung gemäß DE 100 53 206 C1 besitzt die gleichen Nachteile wie die in Figur 4 gezeigte Logikeinrichtung, insbesondere hinsichtlich der Abhängigkeit des Schaltverhaltens von der Größe der Signalströme und der beschränkten Auswahl zwischen verschiedenen Logikfunktionen. Eine derartige Auswahl ist zwar möglich, erfordert aber die Bereitstellung eines zusätzlichen magnetischen Feldes und die Ausnutzung eines sogenannten Asteroid-Schaltverhaltens. Damit ergeben sich Beschränkungen in Bezug auf die Auswahl des Materials, der physikalischen Eigenschaften, der Geometrie und der Dimensionen der Stellelemente.

In DE 101 13 787 ist eine ähnliche programmierbare Logikeinrichtung dargestellt.

Die genannten Nachteile herkömmlicher magnetischer Logikeinrichtungen sind noch stärker ausgeprägt, wenn eine Vielzahl von Logikeinrichtungen in einer Logikschaltung integriert werden soll. Es besteht das Risiko, dass sich benachbarte Logikeinrichtungen stören, indem gegenseitig eine Beeinflussung der Magnetfeldstärken erfolgt. Des Weiteren ist mit den herkömmlichen Logikeinrichtungen eine Miniaturisierung zum Aufbau integrierter Logikschaltungen nur beschränkt möglich.

Die Aufgabe der Erfindung ist es, verbesserte Logikeinrichtungen bereitzustellen, mit denen die Nachteile herkömmlicher Logikeinrichtungen überwunden werden und die sich insbesondere durch einen vereinfachten Aufbau, verminderte Beschränkungen in Bezug auf die Genauigkeit und Stabilität der Einstellung von quantitativen Eingangsparametern und Materialeigenschaften zur Charakterisierung von logischen Eingangsgrößen auszeichnen. Es soll insbesondere die Integrationsfähigkeit im Rahmen integrierter Logikschaltungen erleichtert werden. Die Aufgabe der Erfindung ist es auch, verbesserte Verfahren zum Betrieb magnetischer Logikeinrichtungen vorzuschlagen, mit denen die Nachteile herkömmlicher Verfahren überwunden werden.

Diese Aufgaben werden durch Logikeinrichtungen und Verfahren zu deren Betrieb mit den Merkmalen gemäß den Patentansprüchen 1 oder 11 gelöst. Vorteilhafte Ausführungsformen und Anwendungen ergeben sich aus den abhängigen Ansprüchen.

Vorrichtungsbezogen basiert die Erfindung auf der allgemeinen technischen Lehre, eine magnetische Logikeinrichtung mit mindestens einem magnetischen Element bereitzustellen, dass zwei verschiedene, miteinander gekoppelte Magnetisierungsrichtungen aufweist. Durch die Kopplung der Magnetisierungsrichtungen können mit dem magnetischen Element zwei unabhängige und unterscheidbare Anfangszustände realisiert werden, die für die Einstellung und Ausführung von Logikfunktionen, insbesondere der Funktionen AND, OR, NAND, NOR genutzt werden können. Das magnetische Element besitzt ein durch die Kopplung der Magnetisierungsrichtungen bestimmtes Schaltverhalten, mit dem vereinfacht Zustandsänderungen oder Funktionsausführungen der Logikeinrichtungen realisierbar sind.

Gemäß einer bevorzugten Ausführungsform der Erfindung besteht das magnetische Element aus einer einzigen ebenen Schicht aus magnetischem Material, dessen Magnetisierungsrichtungen gekoppelt sind. In diesem Fall ergeben sich besondere Vorteile in Bezug auf den vereinfachten Aufbau der Logikeinrichtung mit nur einer Schicht zum Einstellen und Schalten von Zuständen. Wenn die Magnetisierungsrichtungen des magnetischen Elements einerseits parallel zur Schichtebene und andererseits senkrecht auf der Schichtebene verlaufen, können sich Vorteile für die Zuverlässigkeit der Umkehrung der Magnetisierungsrichtungen durch mindestens ein äußeres Magnetfeld ergeben. Die einzelne Schicht des magnetischen Elements wird vorzugsweise durch eine Verbindung der Gruppe der Pnictide, zum Beispiele MnAs gebildet. Dieses Material besitzt den Vorteil, dass die gekoppelten Magnetisierungsrichtungen in einer nach an sich herkömmlichen Abscheidungstechniken gebildeten Dünnschicht als Materialeigenschaft bereitgestellt werden.

Gemäß einer alternativen Ausführungsform der Erfindung besteht das magnetische Element aus mindestens zwei ebenen Schichten aus magnetischen Materialien, die jeweils verschiedene, jedoch miteinander gekoppelte Magnetisierungsrichtungen aufweisen. Bei dieser Gestaltung können sich Vorteile in Bezug auf die Anpassung der Logikeinrichtung an die Anforderungen einer konkreten Anwendung und in Bezug auf einen erweiterten Bereich verwendbarer Materialien ergeben.

Vorteilhafterweise umfasst die erfindungsgemäße Logikeinrichtung einen Schichtaufbau, der das schichtförmige magnetische Element und eine Ausgangsschicht aus magnetischem Material umfasst, mit der die Ausrichtung mindestens einer der Magnetisierungsrichtungen des magnetischen Elements, z. B. auf der Grundlage des GMR-oder TMR-Effekts auslesbar ist. Vorteilhafterweise ist die Ermittlung einer logischen Ausgangsgröße an der Ausgangsschicht mit herkömmlichen Verfahren zur Detektion des logischen Zustands einer magnetischen Logikeinrichtung kompatibel. Alternativ kann die Ausgangsgröße durch andere Verfahren zur Detektion des magnetischen Zustands des magnetischen Elements ermittelt werden.

Ein weiterer Gegenstand der Erfindung ist eine Logikschaltung, die eine Vielzahl erfindungsgemäßer Logikeinrichtungen umfasst.

Verfahrensbezogen basiert die Erfindung auf der allgemeinen technischen Lehre, zur Betätigung einer magnetischen Logikeinrichtung mit einem magnetischen Element die logischen Eingangsgrößen durch die Ausrichtung äußerer Magnetfelder relativ zum magnetischen Element zu bilden, so dass die Ausrichtung von zwei verschiedenen, miteinander gekoppelten Magnetisierungsrichtungen des magnetischen Elements festgelegt wird. Vorteilhafterweise wird erfindungsgemäß das Schaltverhalten der magnetischen Logikeinrichtung durch die geometrische Anordnung und Kopplung von zwei Magnetisierungsrichtungen bestimmt. Daraus ergibt sich die Möglichkeit, zwei unterscheidbare Startzustände durch zwei unabhängige Eingangsgrößen (zwei physikalisch getrennte Magnetfelder) und nicht durch Addition von Feldkomponenten zu schalten. Es kommt entscheidend auf die geometrische Ausrichtung der äußeren Magnetfelder an. Dadurch wird die Zuverlässigkeit des Schaltverhaltens erhöht.

Als Operatorfunktion wird beispielsweise die AND-Funktion ausgeführt, indem ausgehend von einem Startzustand, in dem beide Magnetisierungen des magnetischen Elements mit wenigstens einer Vektorkomponente in negative x- und z-Richtungen weisen, die äu-βeren Magnetfelder entsprechend den jeweiligen Eingangsgrößen ausgerichtet werden, wobei als logische Ausgangsgröße, wenn beide äußeren Magnetfelder in positive x- und z-Richtungen ausgerichtet sind, eine logische Eins und sonst eine logische Null gebildet wird.

Umgekehrt kann als Operatorfunktion die OR-Funktion ausgeführt werden, indem nach Einstellung eines Startzustands, in dem beide Magnetisierungen des magnetischen Elements mit wenigstens einer Vektorkomponente in positive x- und z-Richtungen weisen, die äußeren Magnetfelder entsprechend den jeweiligen Eingangsgrößen ausgerichtet werden, wobei als logische Ausgangsgröße, wenn beide äußeren Magnetfelder in negative x- und z-Richtungen ausgerichtet sind, eine logische Null und sonst eine logische Eins gebildet wird.

Bevorzugte Anwendungen der Erfindung sind einerseits die Ausführung von logischen Operationen, bei denen aus logischen Eingangsgrößen an Eingängen des magnetischen Elements eine logische Ausgangsgröße bspw. an der Ausgangsschicht gebildet wird, und andererseits die Speicherung von Zuständen, die logischen Größen entsprechen.

Weitere Einzelheiten und Vorteile der Erfindung werden im Folgenden unter Bezug auf die beigefügten Zeichnungen beschrieben. Es zeigen:
- Figur 1:: schematische Illustrationen von Startzuständen einer erfindungsgemäßen Logikeinrichtung;
- Figur 2:: Schaltkurven zur Illustration der Funktion eines Pnictid-Dünnschichtbauelements;
- Figur 3:: eine schematische Illustration einer erfindungsgemäßen Logikschaltung; und
- Figur 4:: eine schematische Illustration einer herkömmlichen Logikeinrichtung (Stand der Technik).

Ausführungsbeispiele der Erfindung werden im Folgenden unter beispielhaftem Bezug auf ein Dünnschichtbauelement mit einem magnetischen Element aus einer Verbindung aus der Gruppe der Pictide, insbesondere MnAs beschrieben. Es wird betont, dass die Umsetzung der Erfindung nicht auf die beschriebenen Strukturen und Materialien beschränkt, sondern allgemein mit anderen magnetischen Elementen realisierbar ist, die die beschriebene Kopplung verschiedener Magnetisierungsrichtungen aufweisen. Eine erfindungsgemäße Logikeinrichtung kann insbesondere ein oder mehrere magnetische Elemente mit mehreren magnetischen Teilschichten und/oder mehrere Ein- und/oder Ausgänge besitzen. Des Weiteren können erfindungsgemäß nicht nur die unten genannten logischen Funktionen, sondern auch davon abgeleitete logische oder arithmetische Funktionen, wie z. B. Komplementbildungen, bitbezogene Abfragen, Invertierungen, Vergleichsoperationen u.s.w. realisiert werden. Die Erfindung wird im Folgenden unter Bezug auf Referenzrichtungen erläutert, die die x- und z-Raumrichtungen eines kartesischen Koordinatensystems bilden, was lediglich der Klarheit der Darstellung dient und keine Beschränkung darstellt.

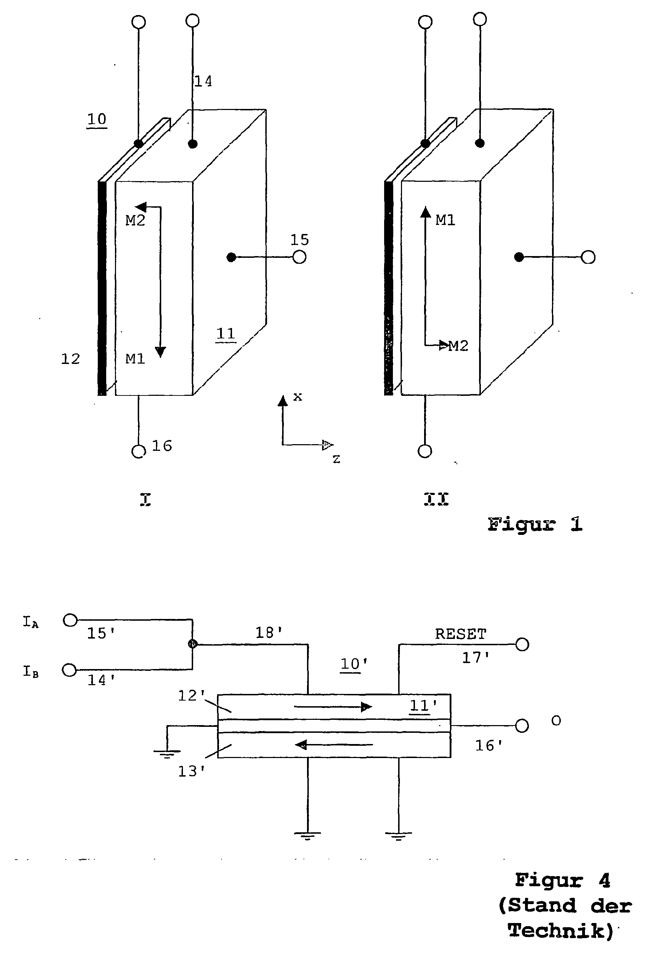

Eine erfindungsgemäße magnetische Logikeinrichtung 10 umfasst mindestens ein magnetisches Element 11, das in Figur 1 mit zwei verschiedenen magnetischen Zuständen illustriert ist. Das magnetische Element 11, das bspw. durch eine MnAs-Schicht mit einer Dicke von z. B. 60 nm auf einem Substrat (nicht dargestellt) gebildet ist, besitzt zwei unterscheidbare und gekoppelte Magnetisierungsrichtungen M1, M2. Die Magnetisierungsrichtungen M1, M2 können in allen, zueinander jeweils verschiedenen Raumrichtungen ausgerichtet sein. Aus Übersichtlichkeitsgründen werden im Folgenden von der einen Magnetisierungsrichtung M1 lediglich die Vektorkomponente, die in der Ebene des magnetischen Elements liegt (x-Komponente) und von der anderen Magnetisierungsrichtung M2, die auf der Ebene des magnetischen Elements 11 senkrecht stehende Vektorkomponente (z-Komponente) betrachtet.

Die Logikeinrichtung 10 umfasst ferner mindestens zwei Eingänge 14, 15, die zur Eingabe logischer Eingangsgrößen am magnetischen Element 11 eingerichtet sind. Die schematisch illustrierten Eingänge 14, 15 umfassen jeweils mindestens einen elektrischen Signal-Leiter. Bei Beaufschlagung der Signal-Leiter mit einem Signalstrom wird jeweils ein äußeres Magnetfeld induziert, durch das die Orientierung der gekoppelten Magnetisierungsrichtungen veränderlich ist.

Die Kopplung der Magnetisierungsrichtungen bedeutet, dass bei Umkehrung von einer der Magnetisierungen (z. B. M1 in x-Richtung) auch die jeweils andere Magnetisierungsrichtung (entsprechend M2 in z-Richtung) umgekehrt wird. Die magnetische Logikeinrichtung 10 besitzt zwei magnetische Grund- oder Startzustände I, II, die in den Teilbildern der Figur 1 illustriert sind. Jeder der beiden Zustände kann als Startzustand für eine logische Operation verwendet werden. Ob ausgehend von einem Startzustand eine Umkehrung der Magnetisierung entsprechend einer gewünschten logischen Funktion erfolgt oder nicht, hängt von einem asymmetrischen Schaltverhalten des magnetischen Elements 11 ab. Das asymmetrischen Schaltverhalten ist durch die Kopplung der Magnetisierungsrichtungen bedingt und wird im Einzelnen unten beschrieben.

Die Logikeinrichtung 10 umfasst des Weiteren mindestens einen Ausgang 16, der allgemein zur Ausgabe oder zum Auslesen mindestens einer logischen Ausgangsgröße am magnetischen Element 11 vorgesehen ist. Beispielhaft ist eine Ausgangsschicht 12 illustriert, mit der der Ausgang 16 verbunden ist. Die Ausgangsschicht 12 besteht aus einem magnetischen Material, das bspw. in positiver x-Richtung magnetisiert ist. Je nach der relativen Ausrichtung der Magnetisierungen in der Ausgangsschicht 12 und dem magnetischen Element 11 ist der am Ausgang 16 messbare elektrische Widerstand der Ausgangsschicht 12 hoch (antiparallele Konfiguration) oder niedrig (parallele Konfiguration). Die Ausgangsschicht 12 ist vom magnetischen Element 11 in an sich bekannter Weise magnetisch getrennt, zum Beispiel durch eine Zwischenschicht (nicht dargestellt).

Es wird betont, dass der Ausgang 16 nicht notwendig für die Widerstandsmessung entsprechend dem GMR- oder TMR-Effekt ausgelegt sein muss. Alternativ kann die logische Ausgangsgröße durch jedes Messverfahren detektiert werden, dass geeignet ist, den magnetischen Zustand des magnetischen Elements 11 zu erfassen, wobei bspw. optische, magnetostriktive oder elektrische Messungen am magnetischen Element 11 vorgesehen sein können.

Die elektrischen Signalströme werden vorzugsweise in Pulsform an die Eingänge 14, 15 gelegt, wobei sich Vorteile in Bezug auf den Energieverbrauch und die Vermeidung einer Erwärmung des magnetischen Elements ergeben können. Die Pulse besitzen Pulsdauern im fs- bis ms-Bereich bzw. Frequenzen im GHz- bis kHz-Bereich.

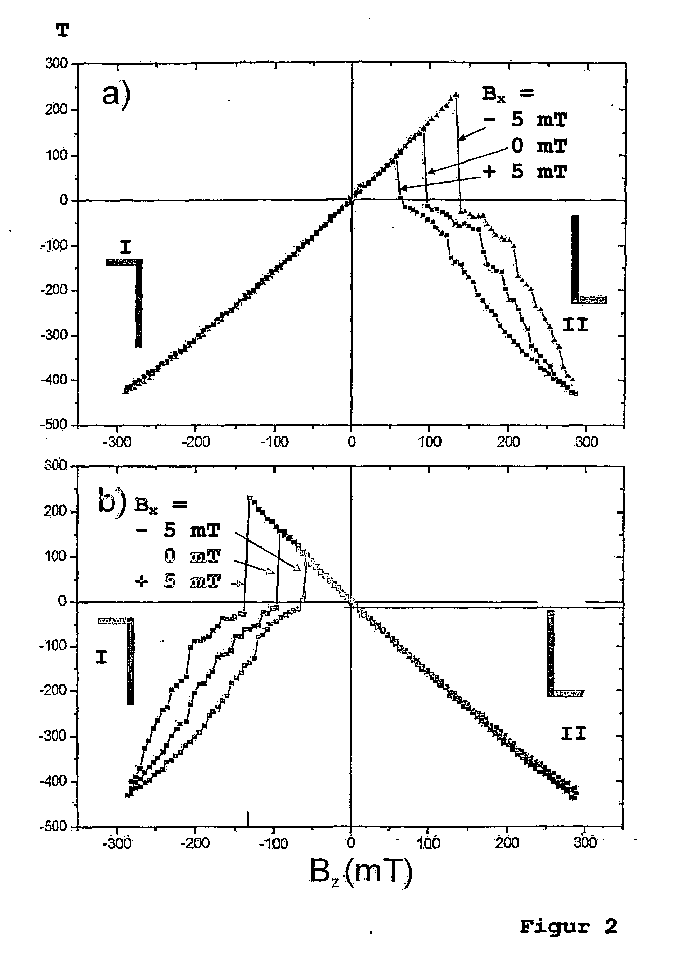

Das asymmetrische Schaltverhalten magnetischer Elemente mit gekoppelten Magnetisierungsrichtungen ist in Figur 2 für die zwei Startzustände I (Teilbild a) und II (Teilbild b) gezeigt. Eine MnAs-Schicht auf einem GaAs-Substrat wurde verschiedenen äußeren Magnetfeldern in x- und z-Richtung ausgesetzt. Eine mit der Messapparatur erfassbare Verbiegung T (willkürliche Einheiten) der Probe repräsentiert den aktuellen magnetischen Zustand (I oder II) und das Umspringen zwischen beiden Zuständen (Umkehrung des Vorzeichens der Verbiegungsänderung bei jeweils steigender z-Feldstärke). Die Kurven zeigen die Abhängigkeit der Größe T (Ordinate) von der Feldstärke in z-Richtung B_{z} (Abszisse) beim Durchlauf von einer negativen z-Ausrichtung zu einer positiven z-Ausrichtung (Teilbild A) und umgekehrt von der positiven z-Ausrichtung zur negativen z-Ausrichtung (Teilbild b) mit der Ausrichtung des x-Magnetfeldes Bₓ als Kurvenparameter.

In Teilbild a ist der Übergang vom magnetischen Zustand I (siehe Figur 1) zum magnetischen Zustand II gezeigt. Im magnetischen Zustand I sind beide Magnetisierungsrichtungen in die negativen x- und z-Raumrichtungen gerichtet. Wird die z-Feldstärke vermindert und in die positive z-Richtung umgekehrt, so erfolgt die sprunghafte Änderung der Größe T, die den Übergang in den magnetischen Zustand II repräsentiert. Der Übergang in den anderen Zustand II erfolgt für ein positives x-Magnetfeld zuerst und für ein negatives x-Magnetfeld zuletzt. Dies bedeutet, dass der magnetische Zustand I beim Anliegen eines Magnetfeldes in negativer x-Richtung gegen das umgekehrte z-Magnetfeld am längsten stabilisiert wird. Diese Erscheinung ist damit zu erklären, dass der in negative x-Richtung gerichtete Anteil beim magnetischen Zustand I durch das äußere negative x-Magnetfeld festgehalten wird, bis das positive z-Magnetfeld genügend stark ist, das ein Umklappen in den magnetischen Zustand II erfolgt.

Beim umgekehrten Verlauf vom magnetischen Zustand II hin zum magnetischen Zustand I (Teilbild b) ergibt sich der umgekehrte Effekt. Die positive x-Komponente des magnetischen Zustands II wird durch das äußere x-Magnetfeld festgehalten und damit der magnetische Zustand II bei Umkehrung des z-Magnetfeldes am längsten stabilisiert.

Das in Figur 2 gezeigte Schaltverhalten mit der asymmetrischen Stabilisierung des magnetischen Zustands I durch ein negatives x-Magnetfeld und des magnetischen Zustands II durch ein positives x-Magnetfeld wird zur Realisierung der Logikfunktionen AND und OR verwendet, wie im Folgenden erläutert wird.

Zur Realisierung der AND-Funktion wird vom magnetischen Zustand I (siehe Fig. 1, Fig. 2, Teilbild a) ausgegangen. Wenn am Eingang 14 ein negatives z-Magnetfeld anliegt, so erfolgt unabhängig vom x-Magnetfeld in keinem Fall ein Umschalten des magnetischen Zustands des magnetischen Elements 11. Am Ausgang 16 wird sowohl für ein negatives als auch für ein positives x-Magnetfeld die negative z-Richtung als Zustand "down" detektiert, der einer logischen Null ('0') entspricht. Beim Anlegen eines positiven z-Magnetfeldes am Eingang 14 hängt der Gesamtzustand aufgrund der stabilisierenden Wirkung des x-Magnetfeldes von der Ausrichtung des über den Eingang 15 erzeugten x-Magnetfeldes ab. Diese Abhängigkeit ist in einem Feldstärkebereich des z-Magnetfelds gegeben, der hier auch als Schaltbereich bezeichnet wird. Wenn das x-Magnetfeld in negative Richtung gerichtet ist, bleibt es beim magnetischen Zustand I. Wenn es hingegen in positive Richtung gerichtet ist, so kehrt sich der Zustand des magnetischen Elements 11 in den magnetischen Zustand II um. Entsprechend ist das x-Magnetfeld positiv ausgerichtet ("up") was einer logischen Eins ('1') entspricht. Die Lage und Größe des Schaltbereiches hängt von den verwendeten Materialien ab und kann durch einfache Versuche ermittelt werden.

Die verschiedenen Zustände der AND-Funktion sind in der folgenden Logiktabelle zusammengefasst.

| Eingang 14 (B_{z}) | Eingang 15 (Bₓ) | Ausgang 16 |
|---|---|---|
| -100 mT ("0") | -5 mT ("0") | down ("0") |
| -100 mT ("0") | +5 mT ("1") | down ("0") |
| +100 mT ("1") | -5 mT ("0") | down ("0") |
| +100 mT ("1") | +5 mT ("1") | up ("1") |

Zur Realisierung der OR-Funktion wird umgekehrt vom Anfangszustand II (siehe Fig. 1, Fig. 2, Teilbild b) ausgegangen. Lediglich wenn im entsprechenden Schaltbereich sowohl das z-Magnetfeld als auch das x-Magnetfeld an den Eingängen 14 und 15 in die negative Raumrichtung ausgerichtet sind, kommt es zum Übergang in den magnetischen Zustand I, der der logischen Null entspricht, während in allen anderen Fällen der magnetische Zustand II entsprechend der logischen I erhalten bleibt.

Die verschiedenen Zustände der OR-Funktion sind in der folgenden Logiktabelle zusammengefasst.

| Eingang 14 (B_{z}) | Eingang 15 (Bₓ) | Ausgang 16 |
|---|---|---|
| -100 mT ("0") | -5 mT ("0") | down ("0") |
| -100 mT ("0") | +5 mT ("1") | up ("1") |
| +100 mT ("1") | -5 mT ("0") | up ("1") |
| +100 mT ("1") | -5 mT ("1") | up ("1") |

Zur Durchführung einer logischen Operation erfolgt somit zunächst ggf. ein Rücksetzen des magnetischen Elements 11, in dem die Eingänge 14, 15 mit vorbestimmten RESET-Größen beaufschlagt werden, um den Startzustand I oder II einzustellen. In einem zweiten Schritt werden die Eingangsgrößen durch Stromsignale gebildet, die je nach ihrer Stromrichtung eine logische I oder Null repräsentieren und entsprechend den oben zusammengestellten Tabellen je nach dem Startzustand zu einer logischen Ausgangsgröße verknüpft werden. Anschließend kann die Konfiguration am Ausgang 16 ausgelesen werden.

Zur Realisierung der NAND- oder NOR-Funktionen kann die Detektion am Ausgang 16 modifiziert werden, zum Beispiel durch Negation der Ausgangsgröße O oder durch Ummagnetisierung des Ausgangsschicht 12.

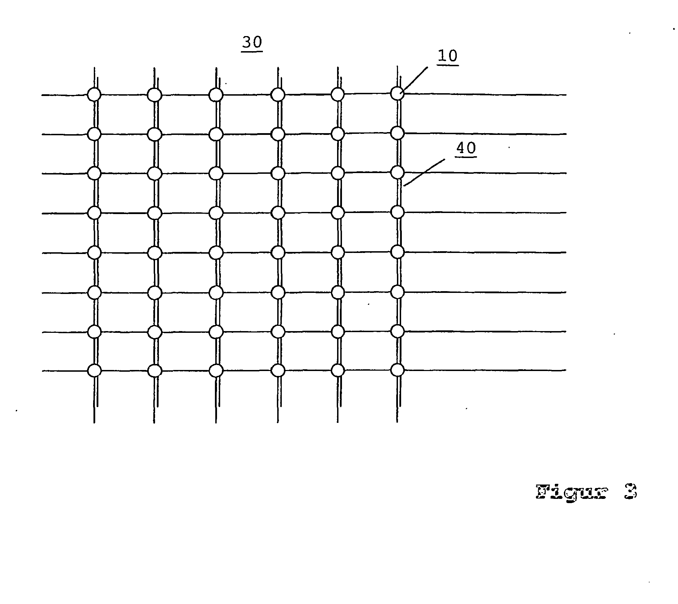

Figur 3 zeigt ausschnittsweise eine erfindungsgemäße Logikschaltung 30 mit einer Vielzahl von matrixartig angeordneten Logikeinrichtungen 10. Jede der Logikeinrichtungen 10 kann analog zu Figur 1 mit einer eigenen Steuerschaltung ausgestattet sein. Alternativ können mehrere oder alle Logikeinrichtungen 10 jeweils mit einer gemeinsamen Steuerschaltung verbunden sein. Die Logikeinrichtungen 10 sind vorzugsweise als integrierte Schaltung angeordnet und über ein Netzwerk 40 von Schreib- und Leseleitungen verknüpft, wie es an sich von herkömmlichen FGPA-Schaltungen oder MRAM-Arrays bekannt ist.

Die in der vorstehenden Beschreibung, den Ansprüchen und den Zeichnungen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Magnetische Logikeinrichtung (10), die ein magnetisches Element (11), mindestens zwei Eingänge (14, 15) und mindestens einen Ausgang (16) aufweist, wobei in Abhängigkeit von logischen Eingangsgrößen (I_{A}, I_{B}) an den Eingängen (14, 15) mindestens eine Magnetisierungsrichtung des magnetischen Elements (11) verstellbar ist, die eine logische Ausgangsgröße O = F (I_{A}, I_{B}) am Ausgang (16) bestimmt, und
das magnetische Element (11) zwei verschiedene, nicht parallele Magnetisierungsrichtungen (M1, M2) aufweist, **dadurch gekennzeichnet, dass** die Magnetisierungs nichten miteinander derart gekoppelt sind, dass bei Umkehrung von einer der Magnetisierungsrichtungen (M1) auch die jeweils andere Magnetisierungsrichtung (M2) umgekehrt wird.

2. Magnetische Logikeinrichtung nach Anspruch 1, bei der das magnetische Element (11) aus einer ebenen Schicht aus einem magnetischem Material besteht, in dem die Magnetisierungsrichtungen (M1, M2) einstellbar sind.

3. Magnetische Logikeinrichtung nach Anspruch 2, bei der eine der Magnetisierungsrichtungen (M1) wenigstens eine Komponente in einer Ebene parallel zu der Schicht aus magnetischem Material und die andere der Magnetisierungsrichtungen (M2) wenigstens eine Komponente in einer Richtung senkrecht zu der Schicht aus magnetischem Material aufweisen.

4. Magnetische Logikeinrichtung nach Anspruch 2 oder 3, bei der das magnetische Material eine Verbindung aus der Gruppe der Pictide umfasst.

5. Magnetische Logikeinrichtung nach Anspruch 4, bei der das magnetische Material MnAs umfasst.

6. Magnetische Logikeinrichtung nach Anspruch 1, bei der das magnetische Element (11) aus mindestens zwei ebenen Schichten aus magnetischen Materialien besteht, wobei in jeder der Schichten eine der Magnetisierungsrichtungen (M1, M2) einstellbar ist.

7. Magnetische Logikeinrichtung nach Anspruch 6, bei der eine der Magnetisierungsrichtungen (M1) wenigstens eine Komponente in einer Ebene parallel zu den Schichten aus magnetischen Materialien und die andere der Magnetisierungsrichtungen (M2) wenigstens eine Komponente in einer Richtung senkrecht zu den Schichten aus magnetischen Materialien aufweisen.

8. Magnetische Logikeinrichtung nach mindestens einem der vorhergehenden Ansprüche, bei der benachbart zum magnetischen Element (11) eine Ausgangsschicht (12) aus magnetischem Material vorgesehen ist, mit der die Ausrichtung der mindestens einen Magnetisierungsrichtung (M1, M2) des magnetischen Elements (11) erfassbar ist.

9. Magnetische Logikeinrichtung nach Anspruch 8, bei der der elektrische Widerstand der Ausgangsschicht (12) von der Ausrichtung der mindestens einen Magnetisierungsrichtung (M1, M2) des magnetischen Elements (11) abhängt und die logische Ausgangsgröße O = F (I_{A}, I_{B}) bestimmt.

10. Logikschaltung (30), die eine Vielzahl von Logikeinrichtungen (10) nach mindestens einem der vorhergehenden Ansprüche aufweist.

11. Verfahren zum Betrieb einer magnetischen Logikeinrichtung (10), die ein magnetisches Element (11), mindestens zwei Eingänge (14, 15) und mindestens einen Ausgang (16) aufweist, wobei durch mindestens eine logische Operation aus logischen Eingangsgrößen (I_{A}, I_{B}) an den Eingängen (14, 15) mit einer Operatorfunktion F mindestens eine logische Ausgangsgröße O = F (I_{A}, I_{B}) am Ausgang (16) gebildet wird; und
als logische Eingangsgrößen (I_{A}, I_{B}) äußere Magnetfelder gebildet werden, deren Ausrichtungen relativ zum magnetischen Element (11) die Ausrichtung von zwei verschiedenen, nicht parallelen Magnetisierungsrichtungen (M1, M2) des magnetischen Elements (11) bestimmen, **dadurch gekennzeichnet, dass** die Magnetisierungsrichtungen (M1, M2) miteinander derart gekoppelt sind, dass bei Umkehrung von einer der Magnetisierungsrichtungen (M1) auch die jeweils andere Magnetisierungsrichtung umgekehrt (M2) wird.

12. Verfahren nach Anspruch 11, bei dem als Operatorfunktion F die AND-Funktion ausgeführt wird, indem nach Einstellung eines Startzustands (I), in dem beide Magnetisierungsrichtungen (M1, M2) des magnetischen Elements (11) in negative x- und z-Richtungen weisen, die äußeren Magnetfelder entsprechend den jeweiligen Eingangsgrößen ausgerichtet werden, wobei als logische Ausgangsgröße, wenn beide äußeren Magnetfelder in positive x- und z-Richtungen ausgerichtet sind, eine logische Eins und in allen anderen Fällen eine logische Null gebildet wird.

13. Verfahren nach Anspruch 11, bei dem als Operatorfunktion F die OR-Funktion ausgeführt wird, indem nach Einstellung eines. Startzustands (II), in dem beide Magnetisierungsrichtungen (M1, M2) des magnetischen Elements (11) in positive x- und z-Richtungen weisen, die äußeren Magnetfelder entsprechend den jeweiligen Eingangsgrößen ausgerichtet werden, wobei als logische Ausgangsgröße, wenn beide äußeren Magnetfelder in negative x- und z-Richtungen ausgerichtet sind, eine logische Null und in allen anderen Fällen eine logische Eins gebildet wird.

14. Verfahren nach Anspruch 12 oder 13, bei dem als Operatorfunktion F die NAND- oder NOR-Funktion ausgeführt wird, indem die logische Ausgangsgröße negiert wird.

15. Verfahren nach mindestens einem der Ansprüche 12 bis 14, bei dem der Zustand des magnetischen Elements (11) nach der logischen Operation als Startzustand für eine folgende logische Operation verwendet wird.

16. Verfahren zum Betrieb einer magnetischen Logikschaltung (30), die eine Vielzahl von Logikeinrichtungen (10) umfasst, mit denen gleichzeitig oder aufeinander folgend eine Vielzahl logischer Operationen gemäß einem Verfahren nach einem der vorhergehenden Ansprüche 12 bis 15 ausgeführt werden.

17. Verwendung einer Logikeinrichtung (10) nach mindestens einem der Ansprüche 12 bis 14 als logisches Bauelement zur Ausführung logischer oder arithmetischer Funktionen oder als Speicherelement zur Speicherung logischer Zustände.

## Claims

1. Magnetic logic device (10) which has a magnetic element (11), at least two inputs (14, 15) and at least one output (16), at least one magnetisation direction of the magnetic element (11) being adjustable in dependence on logic input variables (I_{A},I_{B}) at the inputs (14, 15), determining a logic output variable O = F(I_{A},I_{B}) at the output (16) and the magnetic element (11) having two different, non-parallel magnetisation directions (M1, M2), **characterised in that** the magnetisation directions are so coupled to each other that when one of the magnetisation directions (M1) is reversed, the respective other magnetisation direction (M2) is also reversed.

2. Magnetic logic device according to claim 1, in which the magnetic element (11) comprises a flat layer of a magnetic material in which the magnetisation directions (M1, M2) are adjustable.

3. Magnetic logic device according to claim 2, in which one of the magnetisation directions (M1) has at least one component in a plane parallel to the layer of magnetic material, and the other magnetisation direction (M2) has at least one component in a direction perpendicular to the layer of magnetic material.

4. Magnetic logic device according to claim 2 or 3, in which the magnetic material includes a compound from the group of pictides.

5. Magnetic logic device according to claim 4, in which the magnetic material includes MnAs.

6. Magnetic logic device according to claim 1, in which the magnetic element (11) comprises at least two flat layers of magnetic materials, one of the magnetisation directions (M1, M2) in each of the layers being adjustable.

7. Magnetic logic device according to claim 6, in which one of the magnetisation directions (M1) has at least one component in a plane parallel to the layers of magnetic materials and the other magnetisation direction (M2) has at least one component in a direction perpendicular to the layers of magnetic materials.

8. Magnetic logic device according to at least one of the preceding claims, in which there is provided adjacent to the magnetic element (11) an output layer (12) of magnetic material, with which the alignment of the at least one magnetisation direction (M1, M2) of the magnetic element (11) may be detected.

9. Magnetic logic device according to claim 8, in which the electrical resistance of the output layer (12) depends on the alignment of the at least one magnetisation direction (M1, M2) of the magnetic element (11) and determines the logic output variable O = F (I_{A}, IB).

10. Logic circuit (30) which has a large number of logic devices (10) according to at least one of the preceding claims.

11. Method for operating a magnetic logic device (10) which has a magnetic element (11), at least two inputs (14, 15) and at least one output (16), at least one logical output variable O = F (I_{A},I_{B}) being formed at the output (16) by at least one logic operation from logic input variables (I_{A}, I_{B}) at the inputs (14, 15) with an operator function F, and external magnetic fields being formed as logic input variables (I_{A}, I_{B}), the alignments of which fields relative to the magnetic element (11) determine the alignment of two different, non-parallel magnetisation directions (M1, M2) of the magnetic element (11), **characterised in that** the magnetisation directions are coupled to each other in such a way that when one of the magnetisation directions (M1) is reversed, the respective other magnetisation direction (M2) is also reversed.

12. Method according to claim 11 in which the AND function is executed as the operator function F, by the external magnetic fields being aligned according to the respective input variables after a starting state (I) has been set in which both magnetisation directions (M1, M2) of the magnetic element (11) point in negative x- and z-directions, a logic one being formed as the logic output variable when both the external magnetic fields are aligned in positive x- and z-directions and a logic zero being formed in all other cases.

13. Method according to claim 11, in which the OR function is executed as the operator function F, by the external magnetic fields being aligned according to the respective input variables after a starting state (II) has been set in which both magnetisation directions (M1, M2) of the magnetic element (11) point in positive x- and z-directions, a logic zero being formed as the logic output variable when both the external magnetic fields are aligned in negative x- and z-directions and a logic one being formed in all other cases.

14. Method according to claim 12 or 13, in which the NAND or NOR function is executed as the operator function F, by the logic output variable being negated.

15. Method according to at least one of claims 12 to 14, in which the state of the magnetic element (11) after the logic operation is used as the starting state for a following logic operation.

16. Method for operating a magnetic logic circuit (30) which includes a large number of logic devices (10) with which a large number of logic operations are carried out simultaneously or consecutively as per a method according to one of the preceding claims 12 to 15.

17. Use of a logic device (10) according to at least one of claims 12 to 14 as a logic component for carrying out logical or arithmetic functions or as a storage element for storing logical states.

## Revendications

1. Dispositif logique magnétique (10) qui présente un élément magnétique (11), aux moins deux entrées (14, 15) et au moins une sortie (16), moyennant quoi au moins un sens de magnétisation de l'élément magnétique (11) est variable en fonction de la grandeur des entrées logiques (I_{A}, I_{B}) au niveau des entrées (14, 15), lequel sens de magnétisation détermine une grandeur de sortie logique O = F (I_{A}, I_{B}) au niveau de la sortie (16), et l'élément magnétique (11) présente deux sens de magnétisation (M1, M2) différents non parallèles, **caractérisé en ce que** les sens de magnétisation sont couplés l'un avec l'autre, de sotte qu'en cas d'inversion d'un des sens de magnétisation (M1), l'autre sens de magnétisation (M2) correspondant est également inversé.

2. Dispositif logique magnétique selon la revendication 1, pour lequel l'élément magnétique (11) se compose d'une couche plane d'un matériau magnétique, dans lequel les sens de magnétisation (M1, M2) peuvent être réglés.

3. Dispositif logique magnétique selon la revendication 2, pour lequel un des sens de magnétisation (M1) présente au moins un composant sur un plan parallèle à la couche de matériau magnétique et l'autre sens de magnétisation (M2) présente au moins un composant dans un sens vertical par rapport à la couche de matériau magnétique.

4. Dispositif logique magnétique selon la revendication 2 ou 3, pour lequel le matériau magnétique comprend une liaison du groupe de Pictide.

5. Dispositif logique magnétique selon la revendication 4, pour lequel le matériau magnétique comprend des MnAs.

6. Dispositif logique magnétique selon la revendication 1, pour lequel l'élément magnétique (11) se compose au moins de deux couches planes en matériaux magnétiques, moyennant quoi un des sens de magnétisation (M1, M2) peut être réglé dans chacune des couches.

7. Dispositif logique magnétique selon la revendication 6, pour lequel un des sens de magnétisation (M1) présente au moins un composant sur un plan parallèle aux couches en matériaux magnétiques et l'autre sens de magnétisation (M2) présente au moins un composant dans un sens vertical par rapport aux couches en matériaux magnétiques.

8. Dispositif logique magnétique selon au moins l'une quelconque des revendications précédentes, pour lequel une couche de sortie (12) adjacente à l'élément magnétique (11) et composée d'un matériau magnétique est prévue, avec laquelle l'orientation d'au moins un des sens de magnétisation (M1, M2) de l'élément magnétique (11) peut être saisie.

9. Dispositif logique magnétique selon la revendication 8, pour lequel la résistance électrique de la couche de sortie (12) dépend de l'orientation d'au moins un des sens de magnétisation (M1, M2) de l'élément magnétique (11) et détermine la grandeur de sortie logique O *=* F (I_{A}, I_{B}) .

10. Circuit logique (30) qui présente une pluralité de dispositifs logiques (10) selon au moins l'une quelconque des revendications précédentes.

11. Procédé de fonctionnement d'un dispositif logique magnétique (10), qui présente un élément magnétique (11), au moins deux entrées (14, 15) et au moins une sortie (16), moyennant quoi au moins une grandeur de sortie logique O = F (I_{A}, I_{B}) est formée au niveau de la sortie (16) par au moins une opération logique des grandeurs d'entrée logiques (I_{A}, I_{B}) au niveau des entrées (14, 15) avec une fonction opérationnelle F, et des champs magnétiques externes sont formés comme grandeurs d'entrée logiques (I_{A}, I_{B}), champs dont les orientations par rapport à l'élément magnétique (11) déterminent l'orientation de deux sens de magnétisation (M1, M2) différents non parallèles de l'élément magnétique (11), **caractérisé en ce que** les sens de magnétisation sont couplés l'un à l'autre de sorte qu'en cas d'inversion de l'un des sens de magnétisation (M1), l'autre sens de magnétisation (M2) correspondant est également inversé.

12. Procédé selon la revendication 11, pour lequel la fonction AND est exécutée comme fonction opérationnelle F, tandis qu'après la mise en place d'un état de démarrage (I), dans lequel les deux sens de magnétisation (M1, M2) de l'élément magnétique (11) présentent des sens négatifs x- et z-, les champs magnétiques externes sont orientés conformément aux grandeurs d'entrée correspondantes, moyennant quoi un un logique et dans tous les autres cas un zéro logique est formé comme grandeur de sortie logique lorsque les deux champs magnétiques externes sont orientés dans les sens positifs x-et z-.

13. Procédé selon la revendication 11, pour lequel la fonction OR est exécutée comme fonction opérationnelle F, tandis qu'après la mise en place d'un état de démarrage (II), dans lequel les deux sens de magnétisation (M1, M2) de l'élément magnétique (11) présentent des sens positifs x- et z-, les champs magnétiques externes sont orientés conformément aux grandeurs d'entrée correspondantes, moyennant quoi un un logique et dans tous les autres cas un zéro logique est formé comme grandeur de sortie logique lorsque les deux champs magnétiques externes sont orientés dans les sens négatifs x-et z-.

14. Procédé selon la revendication 12 ou 13, pour lequel la fonction NAND ou NOR est exécutée comme fonction opérationnelle F, tandis que la grandeur de sortie logique est inversée logiquement.

15. Procédé selon au moins l'une quelconque des revendications 12 à 14, pour lequel l'état de l'élément magnétique (11) après l'opération logique est utilisé comme état de démarrage pour une opération logique suivante.

16. Procédé de fonctionnement d'un circuit logique magnétique (30), qui comprend une pluralité de dispositifs logiques (10), avec lesquels une pluralité d'opérations logiques sont exécutées en même temps ou consécutivement selon un procédé selon l'une quelconque des revendications 12 à 15.

17. Utilisation d'un dispositif logique (10) selon au moins l'une quelconque des revendications 12 à 14 comme composant logique destiné à exécuter des fonctions logiques ou arithmétiques ou comme élément d'enregistrement pour enregistrer les états logiques.
